# EUROPEAN PATENT APPLICATION

(11) **EP 4 791 022 A1**
(43) Date of publication of application: **12.08.2026**
(21) Application number: 26156550.1
(22) Date of filing: 05.02.2026
(51) Int. Cl.: H04N 25/704, H04N 25/77, H04N 25/773, H04N 25/78, H04N 25/79

(54) **IMAGE SENSOR AND IMAGE CAPTURE APPARATUS**

(30) Priority: 06.02.2025 JP 2025018543
(71) Applicant: Canon Kabushiki Kaisha, Tokyo, 146-8501 (JP)
(72) Inventor: GOMI, Ryota, Ohta-ku, Tokyo, 146-8501 (JP); NASU, Hitoshi, Ohta-ku, Tokyo, 146-8501 (JP)
(74) Representative: TBK

(57) **Abstract**

Disclosed is an image sensor (10) that comprises a plurality of pixels (110) configured to output pulses in response to photon incidence and a plurality of counters (212) provided in one-to-one correspondence to the plurality of pixels (110) and configured to count pulses output by the corresponding pixel (110). The plurality of pixels (110) includes a focus pixel (120).

## Description

### BACKGROUND

### Field of the Technology

The present disclosure relates to an image sensor and an image capture apparatus.

### Description of the Related Art

A single photon detection type image sensor that uses an avalanche photodiode (APD) is known (Japanese Patent No. 7227777). The image sensor described in Japanese Patent No. 7227777 can perform image plane phase-difference detection type autofocus due to being provided with a plurality of APDs that share a single micro lens in each pixel.

With a known image sensor that uses APDs as photoelectric conversion elements, one counter is provided per APD in order to count the photons incident on the APD. Thus, to achieve image plane phase-difference detection type autofocus, if two APDs are provided in one pixel, two counters are also needed, and this increases the circuitry area of the image sensor.

### SUMMARY

The present disclosure has been made in consideration of the aforementioned problems with known technology and, in at least some of the embodiments of the present disclosure, provides an image sensor that uses pixels configured to output a pulse in response to photon incidence, the image sensor also having a reduced circuit size and enabling image plane phase-difference detection type autofocus.

The present disclosure in its first aspect provides an image sensor as specified in claim 1. Optional features are specified in claims 2 to 6 and 9.

The present disclosure in its second aspect provides an image sensor as specified in claim 7. Optional features are specified in claims 8 and 9.

The present disclosure in its third aspect provides an image capture apparatus as specified in claim 10.

The present disclosure in its fourth aspect provides an image sensor as specified in claim 11. Optional features are specified in claim 12 to 14.

Features of the present disclosure will become apparent from the following description of embodiments with reference to the attached drawings. The following description of embodiments is described by way of example.

### BRIEF DESCRIPTION OF THE DRAWINGS

The accompanying drawings, which are incorporated in and constitute a part of the specification, illustrate embodiments of the present disclosure, and together with the description, serve to explain the principles of the embodiments.
FIG. 1 is a block diagram illustrating a functional configuration of an image capture apparatus that can be applied to an image sensor according to an embodiment.
FIG. 2 is a perspective view illustrating a configuration example of an image sensor according to an embodiment.
FIG. 3 is a diagram illustrating an example of a pixel arrangement according to a first embodiment.
FIG. 4 is an equivalent circuit diagram of a unit pixel according to the first embodiment.
FIG. 5 is a diagram for describing operations of the unit pixel.
FIG. 6 is a timing chart illustrating an example of operations of the unit pixel according to the first embodiment.
FIG. 7 is a timing chart illustrating another example of operations of the unit pixel according to the first embodiment.
FIGS. 8A to 8C are vertical cross-sectional views illustrating examples of the structure of the unit pixel according to the first embodiment.
FIGS. 9A and 9B are diagrams illustrating arrangement examples of a light-blocking curtain according to the first embodiment.
FIG. 10 is an equivalent circuit diagram of a unit pixel according to a second embodiment.
FIG. 11 is a vertical cross-sectional view illustrating an example of the structure of the unit pixel according to the second embodiment.
FIGS. 12A and 12B are diagrams illustrating arrangement examples of an avalanche photodiode of the unit pixel according to the second embodiment.
FIG. 13 is a timing chart illustrating an example of operations of the unit pixel (normal pixel) according to the second embodiment.
FIG. 14 is a timing chart illustrating an example of operations of the unit pixel (focus pixel) according to the second embodiment.
FIGS. 15A to 15C are diagrams illustrating examples of signal reading of each pixel according to the second embodiment.
FIG. 16 is a diagram illustrating another example of a pixel arrangement according to the second embodiment.

### DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

### First Embodiment

### Configuration Example of Image Capture Apparatus

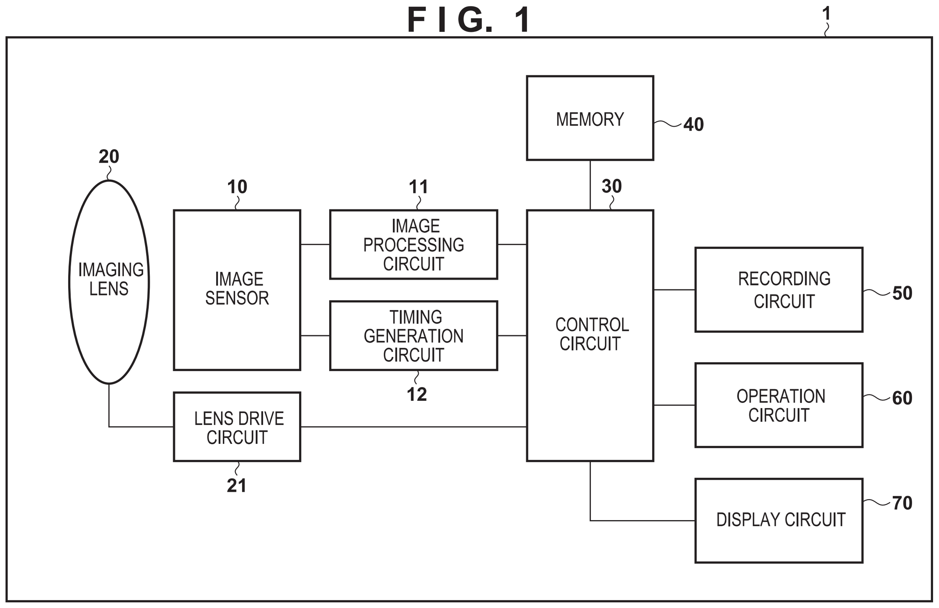

A functional configuration example of an image capture apparatus (digital camera or digital video camera) 1 will now be described as an example of an electronic device that uses an image sensor according to an embodiment using FIG. 1. The image capture apparatus 1 includes an imaging lens 20 that forms an optical image of a subject on an image plane of an image sensor 10. The imaging lens 20 may be an interchangeable lens type that can be attached and detached or may be integrally formed with the image capture apparatus 1.

The imaging lens 20 includes a diaphragm, a focus lens, a zoom lens, or similar movable members and a motor, an actuator, or the like for driving the movable members. The opening/closing of the diaphragm and the movement of the focus lens and zoom lens is controlled by a control circuit 30 via a lens drive circuit 21.

The image sensor 10, for example, may be an image sensor including a primary color Bayer array color filter. The image sensor 10 includes a pixel array including a plurality of pixels in a two-dimensional array and peripheral circuitry for reading signals from each pixel. Each pixel includes one micro lens and a photoelectric conversion element. Also, in the present embodiment, an avalanche photodiode (APD) is used in the photoelectric conversion element, and the photoelectric conversion element is configured to be able to individually read out the number of photons incident on each pixel in an exposure period. Also, a portion of the pixels are configured as focus pixels for obtaining signals to use in image plane phase-difference detection type autofocus. This will be described below in detail. By using APDs in photoelectric conversion elements, pixel values (image data) of digital values can be read out from the image sensor 10. The operations of the image sensor 10 are controlled by signals supplied by a timing generation circuit 12.

An image processing circuit 11 applies predetermined image processing to the image data output by the image sensor 10, generates a signal or image data in accordance with the application, obtains and/or generates various types of information, and the like. The image processing circuit 11 may be, for example, a dedicated hardware circuit such as an application-specific integrated circuit (ASIC) designed to realize a specific function. Alternatively, the image processing circuit 11 may be configured to realize a specific function by a processor such as a digital signal processor (DSP) or a graphics processing unit (GPU) executing software. The image processing circuit 11 outputs the obtained or generated information and data to the control circuit 30.

The image processing applied by the image processing circuit 11 may include, for example, preprocessing, color interpolation processing, correction processing, detection processing, data modification processing, evaluation value calculation processing, special effects processing, and the like.

The preprocessing may include signal amplification, reference level adjustment, defective pixel correction, and the like.

The color interpolation processing is processing for interpolating values of color components not included in the pieces of pixel data forming the image data that is executed in a case where a color filter is provided in the image sensor 10. Color interpolation processing may be referred to as demosaic processing.

Correction processing may include various processing including white balance adjustment, tone correction, correction (image restoration) of image degradation caused by an optical aberration of the imaging lens 20, correction of the effects of vignetting of the imaging lens 20, color correction, and the like.

The detection processing may include processing for detecting a characteristic area (for example, a face area or a human body area) or movement thereof, processing for recognizing a person, and the like.

The data modification processing may include processing including trimming areas (cropping), combining, scaling, encoding and decoding, header information generation (data file generation), and the like. Generating image data for display and image data for storing is also included in the data modification processing.

The evaluation value calculation processing may include processing including generating signals or evaluation values that are used in autofocus (AF), generating evaluation values that are used in autoexposure (AE), and the like. Generation of a signal pair that is used in image plane phase-difference detection type AF is also included in evaluation value calculation processing.

Special effects processing may include processing including adding a blur effect, changing color tone, relighting, and the like.

Note that these are examples of the processing that can be applied by the image processing circuit 11, and are not intended to limit the processing applied by the image processing circuit 11.

The control circuit 30 is one or more processors (CPU, MPU, microprocessor, or the like) that can execute programs, for example. The control circuit 30 controls the operations of each unit of the image capture apparatus 1 to implement the functions of the image capture apparatus 1 by loading programs stored in a non-volatile memory included in a memory 40 into volatile memory (RAM) included in the memory 40 and executing the programs. Note that in a case where the imaging lens 20 is an interchangeable lens, the control circuit 30 communicates with a controller included in the imaging lens 20 and controls the operations of the imaging lens 20.

The memory 40 includes a rewritable non-volatile memory and RAM. The non-volatile memory stores programs executed by the control circuit 30, various types of setting values of the image capture apparatus 1, GUI data, and the like. The RAM is used as a main memory of the control circuit 30, a buffer for temporarily storing captured image data, a working memory for temporarily storing data being processed by the image processing circuit 11, and the like. Also, a portion of the RAM may be used as video memory for storing image data for display.

A recording circuit 50 records image data obtained via image capture in a storage medium such as a memory card, for example. The recording circuit 50 also reads out data recorded in the storage medium and stores the data in the memory 40. The operations of the recording circuit 50 are controlled by the control circuit 30.

An operation circuit 60 is a generic term for an input device (buttons, switches, dials, and the like) that is provided for the user to input instructions to the image capture apparatus 1. Each of the input devices constituting the operation circuit 60 has a name corresponding to the function allocated to it. Examples include a release switch, a video record switch, an image capture mode selection dial, a menu button, a directional key, an enter key, and the like. The release switch is a switch for recording a still image, and the control circuit 30 executes image capture preparation operations such as AF and AE when a half-press state of the release switch is detected. Also, the control circuit 30 executes a sequence of operations (image capture operations) from still image capture to recording when a full-press state of the release switch is detected. Also, the control circuit 30 executes a video record operation when the video record switch is pressed in an image capture standby state and stops the record operation when the video record switch is pressed while video is being recorded. Note that the functions allocated to the same input device may be variable. Also, the input device may be software buttons or keys using a touch display. The operation circuit 60 may also include an input device that supports non-contact input methods such as voice input and eye-gaze input.

A display circuit 70 is provided in the casing of the image capture apparatus 1 and displays the settings of the image capture apparatus 1, menu screens, live view images, playback images, and the like. The display circuit 70 that displays live view images functions as an electronic viewfinder (EVF). The display circuit 70 may be a dot matrix color display such as a liquid crystal display. Also, the display circuit 70 may be a touch display.

### Configuration Example of Image Sensor

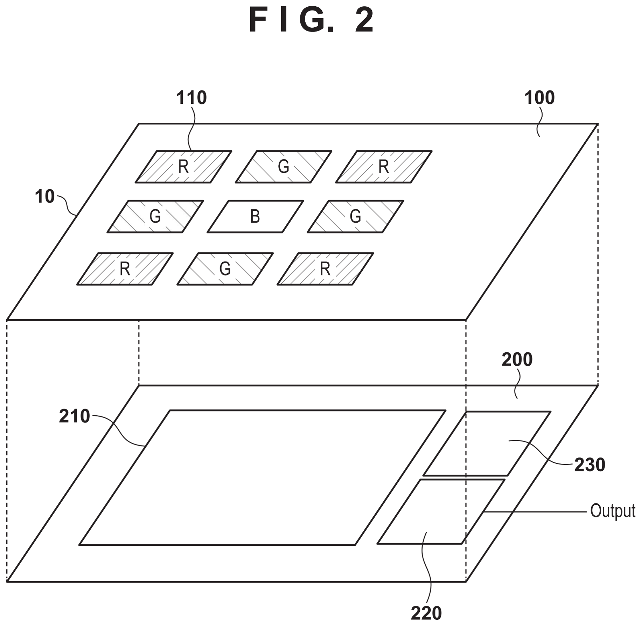

FIG. 2 is a perspective view schematically illustrating the configuration of the image sensor 10. The image sensor 10 has a stacked structure including a sensor substrate 100 and a circuit substrate 200. Note that the circuitry for implementing functions equivalent to those of the sensor substrate 100 and the circuit substrate 200 may be implemented via a single layer structure.

On the sensor substrate 100, a pixel array with a plurality of unit pixels 110 arranged in a matrix is formed. In each of the unit pixels 110, a micro lens for improving the light-collecting efficiency of incident light and a red (R), green (G), or blue (B) color filter are formed. The detailed circuitry configuration of the unit pixels 110 will be described below.

On the circuit substrate 200, a counting unit 210, a signal processing circuit 220, and a substrate memory 230 are provided. The counting unit 210 is electrically connected to each of the unit pixels of the sensor substrate 100 via a bump or the like. The counting unit 210 outputs control signals for driving the unit pixels 110 and receives buffer outputs from the unit pixels 110. The counting unit 210 counts the pulses output in response to photon incidence by the unit pixels 110 for each of the unit pixels 110. The substrate memory 230 is volatile memory such as DRAM or the like. The substrate memory 230 temporarily stores the value (count value) counted by the counting unit 210, for example. The substrate memory 230 may also be used for other purposes. The signal processing circuit 220 performs various types of computations with the count value stored in the substrate memory 230 and outputs to outside of the image sensor 10.

### Pixel Arrangement Example

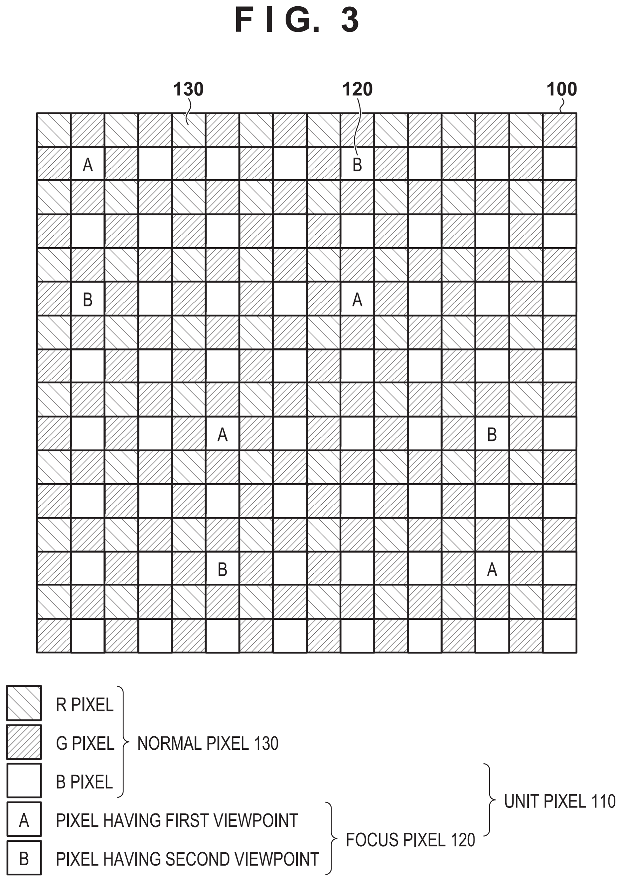

FIG. 3 is a diagram illustrating an arrangement example of pixels provided in a pixel array on the sensor substrate 100. As illustrated, in the pixel array, normal pixels 130 and focus pixels 120 are arranged. The normal pixels 130 include a red (R), green (G), or blue (B) color filter and are pixels that are used for obtaining a captured image. The focus pixels 120, however, do not include a color filter and are not used in obtaining a captured image. The focus pixels 120 are used for generating a signal pair used in image plane phase-difference detection type autofocus.

The focus pixels 120 are considered to be defective pixels when a captured image is obtained, and at the time when a captured image is obtained, the pixel values at the positions of the focus pixels 120 are estimated via interpolation from the values of the surrounding normal pixels 130. Then, to suppress a reduction in the accuracy of the interpolation, the focus pixels 120 are discretely arranged in the pixel array.

The focus pixels 120 consist of pairs of an A pixel and a B pixel with different viewpoint positions in the horizontal direction or the vertical direction. Of the focus pixels 120 included in a focus detection area, a signal pair of a signal generated from a group of the A pixels and a signal generated from a group of the B pixels is used in the image plane phase-difference detection type autofocus.

### Unit Pixel Configuration Example

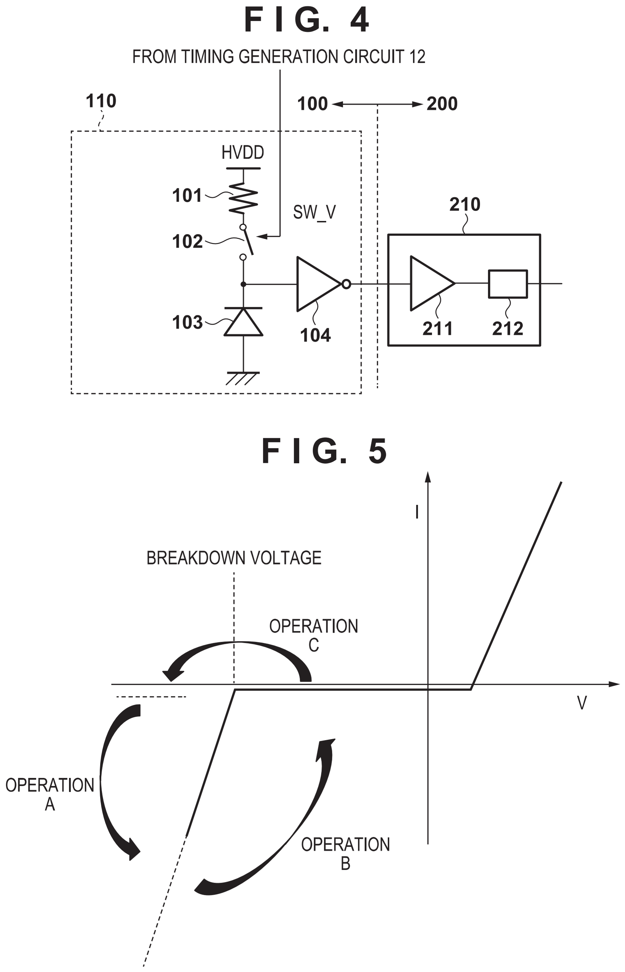

FIG. 4 is an equivalent circuit diagram illustrating a configuration example of the unit pixel 110. The unit pixel 110 includes a quenching resistor 101, a switch 102, an avalanche photodiode (APD) 103, and a buffer 104.

The APD 103 is connected to a voltage HVDD via the quenching resistor 101 and the switch 102. The opening and closing of the switch 102 is controlled via a control line (not illustrated). When the switch 102 is closed, a reverse bias voltage from the voltage HVDD is applied to the APD 103. When the switch 102 is closed, the voltage HVDD is set in such a manner that a reverse bias voltage equal to or greater than a breakdown voltage is applied to the APD 103. Accordingly, when the switch 102 is closed, the APD 103 operates in the Geiger mode.

The input of the buffer 104 is connected between the APD 103 and the switch 102, and the output is connected to one of the counting units 210 provided on the circuit substrate 200. In the counting unit 210, the output of the buffer 104 and a reference voltage are compared by a comparator 211. The comparator 211, for example, outputs different levels of voltage in a case where the output of the buffer 104 is higher than the reference voltage and in a case where the output is equal to or less than the reference voltage. The changes (for example, rises) in the output level of the comparator 211 are counted by a counter 212.

### Unit Pixel Operations

The operations of the unit pixel 110 at the time of photon incidence will now be described. FIG. 5 illustrates the current/voltage characteristics of the APD 103. The reverse bias voltage HVDD greater than the breakdown voltage (break voltage) is applied to the cathode of the APD 103, and the APD 103 operates in Geiger mode. In this condition, when a photon is incident on the APD 103, a large current (photocurrent) caused by avalanche amplification flows through the APD 103 (operation A). At the same time, a voltage drop is caused by the quenching resistor 101, and when the reverse bias voltage applied to the APD 103 becomes less than the breakdown voltage, the avalanche amplification stops (operation B). When the avalanche amplification stops, the reverse bias voltage applied to the cathode of the APD 103 increases, and the APD 103 returns to Geiger mode (operation C).

The changes in the input voltage of the buffer 104 during the operations A to C are pulse shaped by the buffer 104 and input to the comparator 211, and ultimately, the count value of the counter 212 increases by 1. Since the operations A to C are performed each time a photon is incident on the APD 103, the photons incident on the APD 103 within a predetermined time period can be counted by the counter 212.

In the following description, for the sake of convenience, the following signal names will be used:
· APD_V: Waveform generated by the quenching resistor 101, the switch 102, and the APD 103 (input of the buffer 104);
· PLS_V: Output of the buffer 104;
· SW_V: Signal for controlling the opening and closing of the switch 102;
· CNT_RST: Signal for resetting the count value of the counter 212;
· CNT_EN: Signal for controlling the counting operation of the counter 212; and
· CNT_NUM: The count value of the counter 212.

Of these, the control signals SW_V, CNT_RST, and CNT_EN are supplied from the timing generation circuit 12 according to control by the control circuit 30. Also, the timing generation circuit 12 can generate two or more types of control signals and simultaneously output different control signals. For example, the timing generation circuit 12, as described below, can make the switch control signal SW_V supplied to the focus pixels 120 and the switch control signal SW_V supplied to the normal pixels 130 different. Also, a circuit for generating these control signals may be provided on the circuit substrate 200.

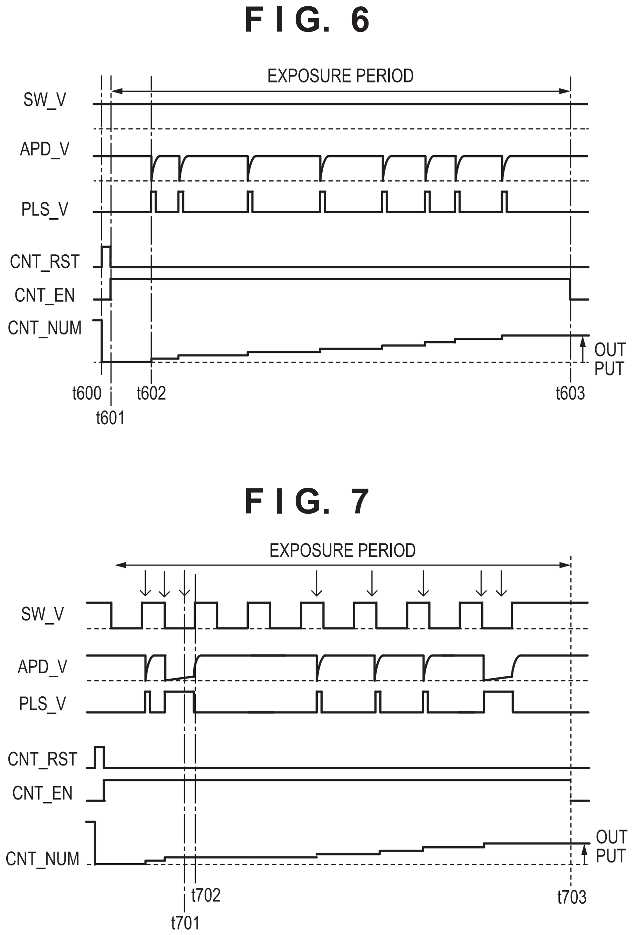

FIG. 6 is a timing chart illustrating an example of operations of the unit pixels 110 at the time of image capture. Exposure of the unit pixels 110 and the reading operation (photon counting operation) from the unit pixels 110 by the counting unit 210 are illustrated. An optical image of the subject is converted into image data by performing the operations illustrated in FIG. 6 in parallel for each of the unit pixels 110.

When the switch control signal SW_V goes to high level (referred to below as "H"), the switch 102 is closed and the APD 103 operates in Geiger mode. The APD 103 in Geiger mode is in an active state that produces avalanche multiplication via photon incidence. On the other hand, when the switch control signal SW_V goes to low level (referred to below as "L"), the switch 102 is set to off. Accordingly, even if the avalanche amplification is stopped, the reverse bias voltage applied to the cathode of the APD 103 does not increase, and the APD 103 does not return to Geiger mode. Since the APD 103 does not return to Geiger mode, the APD 103 is in an inactive state in which avalanche multiplication is not produced even if a photon is incident. When the counter reset signal CNT_RST becomes "H", the count value of the counter 212 is reset to 0. Also, the counter 212 counts the pulse number only during the time period in which the counter enable signal CNT_EN is "H".

The driving of the unit pixels 110 will now be described. The switch control signal SW_V is maintained at "H" to make the APD 103 active.

At time t600, the counter reset signal CNT_RST goes to "H" and the count value of the counter 212 is reset to 0.

At time t601 when the exposure period starts, the counter reset signal CNT_RST goes to "L" and resetting of the counter 212 ends. At the same time, the counter enable signal CNT_EN goes to "H" and the counting operation of the counter 212 is started.

At time t602, when a photon is incident on the APD 103, an avalanche multiplication is produced, and the APD_V potential changes. Since the charge produced by the avalanche multiplication is discharged via the quenching resistor 101, it takes time for the APD_V to become a constant potential again. Also, the output PLS_V of the buffer 104 returns to "L" after going to the "H" level for a short amount of time in response to the falling edge of the APD_V. In this manner, the buffer 104 generates a voltage pulse when a photon is incident on the APD 103. The voltage pulses are counted by the counter 212 via the comparator 211, and the count value CNT_NUM of the counter 212 goes from 0 to 1.

Thereafter, in the time until time t603 when the exposure period ends, a voltage pulse is generated by the buffer 104 each time a photon is incident on the APD 103 and the count value of the counter 212 increases.

At time t603, the counter enable signal CNT_EN goes to "L" and the exposure period ends. The counter 212 outputs the count value at the time when the exposure period ended to the signal processing circuit 220 as the value of the unit pixel 110.

From the count values of the normal pixels 130, captured image data for display or recording can be generated. Also, from the count values of the focus pixels 120, a signal pair used in phase-difference detection type autofocus can be generated.

FIG. 7 is a timing chart illustrating another example of operations of the unit pixels 110 at the time of image capture. Here, a method of adjusting the sensitivity of the unit pixel 110 using the switch control signal SW_V supplied to the unit pixel 110 will be described.

As described below, a light-blocking curtain 500, which is an example of a light blocking element that blocks light for a portion of the photoelectric conversion area, is provided in the focus pixel 120, and this gives the focus pixels 120 less sensitivity than the normal pixels 130. The difference in sensitivity can be reduced using a duty ratio (ratio of H level time period) of the switch control signal SW_V supplied to the normal pixels 130 and the focus pixels 120.

The timing chart of FIG. 7 is different from the timing chart of FIG. 6 in that there is a time period in which the switch control signal SW_V goes to "L". In other words, the switch control signal SW_V of FIG. 7 has a lower duty ratio than the switch control signal SW_V of FIG. 6. Also, in FIG. 7, the down arrows represent photon incidence on the APD 103.

As indicated at time t701, even if there is photon incidence during the time when the switch control signal SW_V is "L", because the APD_V is in an inactive state, avalanche multiplication is not produced.

At time t702, the switch control signal SW_V goes to "H", the APD 103 is recharged and enters an active state, and the APD_V goes to "H". In the time period in which the APD_V is "H", when a photon is incident on the APD 103, an avalanche multiplication is produced, and the count value increases. Since the amount of time required to recharge the APD 103 is short, basically, if a photon is incident on the APD 103 in the time period in which the switch control signal SW_V is "H", the count value increases.

In FIG. 7, the "H" time periods and the "L" time periods of the switch control signal SW_V are repeated, and thus compared to a case where the switch control signal SW_V is always "H" as in FIG. 6 and the light incidence is as illustrated in FIG. 7, the count value at the end of the exposure period is less. This is synonymous with the sensitivity of the unit pixel supplied with the switch control signal SW_V as illustrated in FIG. 7 being lower than the sensitivity of the unit pixel supplied with the switch control signal SW_V as illustrated in FIG. 6.

In this manner, the sensitivity of the unit pixels 110 can be adjusted via the duty ratio of the switch control signal SW_V supplied to the unit pixels 110.

Thus, by making the duty ratio of the switch control signal SW_V supplied to the focus pixels 130 less than the duty ratio of the switch control signal SW_V supplied to the normal pixels 120, the difference in sensitivity between the focus pixels 120 and the normal pixels 130 can be reduced.

The specific difference in duty ratio can be set in accordance with the difference in sensitivity between the focus pixels 120 and the normal pixels 130.

Also, sensitivity adjustment of the unit pixels 110 via the duty ratio of the switch control signal SW_V may be performed for a purpose other than reducing the difference in sensitivity between the focus pixels 120 and the normal pixels 130.

### Unit Pixel Structure Example

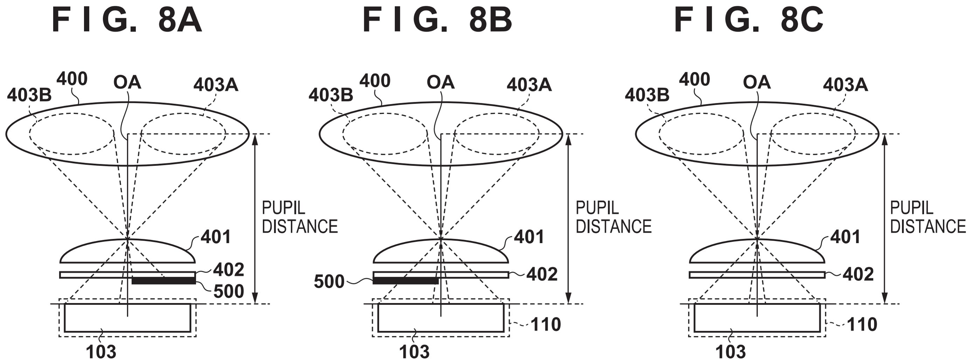

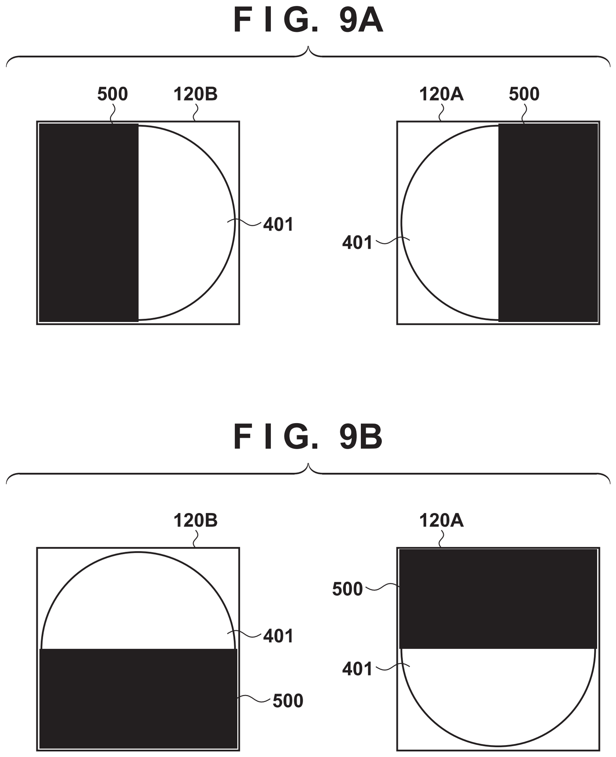

FIGS. 8A to 8C are vertical cross-sectional views illustrating examples of the structure of the focus pixels 120 and the normal pixels 130. FIGS. 8A and 8B illustrate the focus pixel 120, and FIG. 8C illustrates the normal pixel 130. The focus pixel 120 includes the light-blocking curtain 500 provided to block light to half of the photoelectric conversion area of the APD 103. The light-blocking curtain 500 is provided in a first focus pixel (referred to as focus pixel 120A) illustrated in FIG. 8A and a second focus pixel (referred to as focus pixel 120B) illustrated in FIG. 8B blocking light in different areas. Here, as illustrated in FIG. 9A, the light-blocking curtain 500 is provided in the focus pixel 120A in such a manner as to block light to the right half of the photoelectric conversion area in the horizontal direction and is provided in the focus pixel 120B in such a manner as to block light to the left half of the photoelectric conversion area in the horizontal direction.

In FIGS. 8A to 8C, 400 denotes the exit pupil of the imaging lens 20 and OA denotes the optical axis of the imaging lens 20. Also, the distance from the exit pupil 400 to the unit pixel 110 is the pupil distance. Here, to illustrate which area of the exit pupil 400 the light that is incident on the APD 103 is from, the exit pupil 400 is illustrated rotated 90 degrees about an axis extending in the left-and-right direction of the diagram.

The light incident on the APD 103 of the focus pixel 120A is mainly light that passes through a pupil area 403A. The light that passes through a pupil area 403B is blocked by the light-blocking curtain 500 and is not incident on the APD 103. In a similar manner, the light incident on the APD 103 of the focus pixel 120B is mainly light that passes through the pupil area 403B. The light that passes through the pupil area 403A is blocked by the light-blocking curtain 500 and is not incident on the APD 103. On the other hand, for the APD 103 of the normal pixel 130 without the light-blocking curtain 500, both the light that passes through the pupil area 403A and the light that passes through the pupil area 403B are incident on the APD 103.

In this manner, the focus pixel 120A and the focus pixel 120B with the light-blocking curtain 500 provided at different positions mainly receive light of different pupil areas of the exit pupil 400 of the imaging lens 20. This corresponds to the focus pixels 120A and 120B capturing an image at different viewpoints. Thus, the image formed with the pixel values obtained from the focus pixel 120A and the image formed with the pixel values obtained from the focus pixel 120B form a parallax image pair. Accordingly, the phase-difference detection type autofocus can be performed based on the phase difference between a signal (A signal) generated from the pixel values of the focus pixels 120A group and a signal (B signal) generated from the pixel values of the focus pixels 120B group, the focus pixels 120A group and the focus pixels 120B group both existing in the same pixel area in a pixel array. The A signal and the B signal are each referred to as a focus signal.

The image processing circuit 11 generates the A signal and the B signal using the values of the focus pixels included in the area corresponding to the set focus detection area of the pixel array. The control circuit 30 detects the phase difference between the A signal and the B signal and converts the phase difference to a defocus amount. Then, the control circuit 30 controls the lens drive circuit 21 and moves the focus lens included in the imaging lens 20 in a direction and by an amount in accordance with the defocus amount to focus on the subject in the focus detection area. Phase-difference detection type autofocus is a known technology, and thus further details will not be described.

Note that the position of the light-blocking curtain provided in the focus pixel may be made different in the up-and-down direction as illustrated in FIG. 9B. Also, both the group of focus pixels provided with the light-blocking curtain as illustrated in FIG. 9A and a group of focus pixels provided with the light-blocking curtain as illustrated in FIG. 9B may be arranged in the pixel array.

According to the present embodiment, a portion of a plurality of pixels arranged in a pixel array of an image sensor are made focus pixels. Accordingly, even with an image sensor with a configuration that uses a single photon detection type photoelectric conversion element for the pixel photoelectric conversion element, image plane phase-difference detection type autofocus can be performed without using a plurality of counters per pixel. Thus, an increase in the circuit size can be suppressed.

### Second Embodiment

Next, the second embodiment will be described. In the present embodiment, the unit pixel includes a plurality of photoelectric conversion elements. Note that the configurations shared with the first embodiment such as the configuration of the image capture apparatus 1 and the like will not be described.

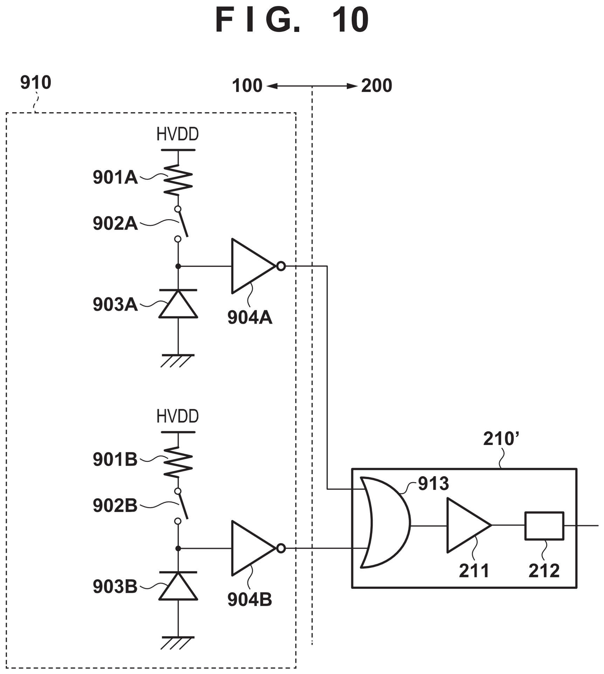

FIG. 10 is an equivalent circuit diagram illustrating an example configuration of a unit pixel 910 included in the image sensor 10 according to the second embodiment. The unit pixel 910 includes two configurations similar to the unit pixel 110 in the first embodiment. 901A and 901B correspond to 101 of FIG. 4, 902A and 902B correspond to 102 of FIG. 4, 903A and 903B correspond to 103 of FIG. 4, 904A and 904B correspond to 104 of FIG. 4, and since the functions are the same, these will not be described.

In the present embodiment, the output of the two buffers 904A and 904B included in the unit pixel 910 is input to a single counting unit 210'. The counting unit 210' has the same configuration as the counting unit 210 according to the first embodiment except that a logical disjunction (OR) circuit 913 is added upstream of the comparator 211. The OR circuit 913 outputs the logical disjunction of the two outputs of the unit pixel 910 to the comparator 211.

Accordingly, in a case where both the APD 903A and the APD 903B are in Geiger mode, if a photon is incident on at least one of the APDs, the count value of the counter 212 increases. Also, in a case where either the APD 903A or the APD 903B is in Geiger mode, if a photon is incident on the APD in Geiger mode, the count value of the counter 212 increases.

In this manner, by closing one or both of the switches 902A and 902B, the count of photons incident on any one APD and the count of photons incident on both APDs can be switched between. Accordingly, the unit pixel 910 can be used as the focus pixel 120 or as the normal pixel 130 according to the first embodiment.

Specifically, the unit pixel 910 with the switch 902A closed and the switch 902B open functions as the focus pixel 120A (or 120B) according to the first embodiment. Also, the unit pixel 910 with the switch 902B closed and the switch 902A open functions as the focus pixel 120B (or 120A) according to the first embodiment. Furthermore, the unit pixel 910 with both of the switches 902A and 902B closed functions as the normal pixel 130 according to the first embodiment.

### Unit Pixel Structure Example

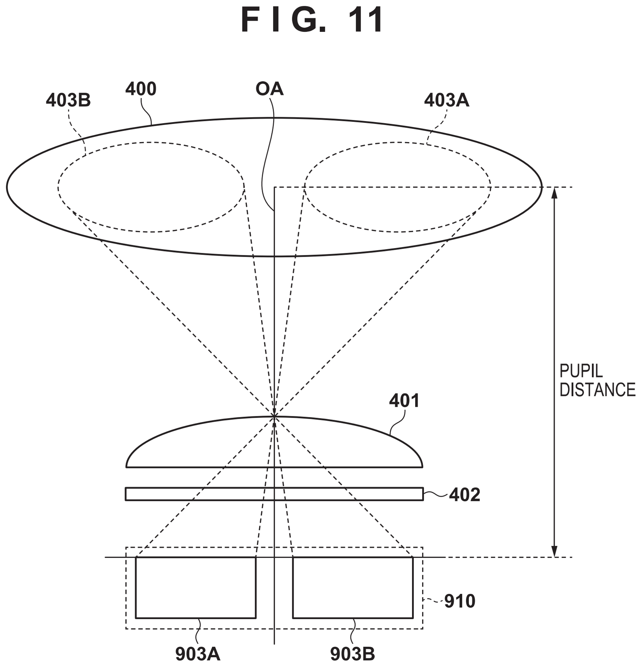

FIG. 11 is a vertical cross-sectional view illustrating an example of the structure of the unit pixel 910 according to the present embodiment, with configurations that are shared with the unit pixel 110 of the first embodiment being given the same reference number as in FIGS. 8A to 8C. In the unit pixel 910, the photoelectric conversion area of the normal pixel 130 according to the first embodiment is configured of the two APDs 903A and 903B.

The light incident on the APD 903A is mainly light that passes through the pupil area 403A of the exit pupil 400 of the imaging lens 20. In a similar manner, the light incident on the APD 903B is mainly light that passes through the pupil area 403B. The unit pixel 910 with the APD 903A active and the APD 903B inactive is the same as a configuration with a light-blocking curtain provided on the APD 903B in terms of mainly detecting only the light that passes through the pupil area 403A. Thus, the unit pixel 910 functions similarly to the focus pixel 120A according to the first embodiment. In a similar manner, the unit pixel 910 with the APD 903A inactive and the APD 903B active functions similarly to the focus pixel 120B according to the first embodiment.

Thus, the A signal can be generated from the pixel values obtained from the unit pixels 910 with the APD 903A active and the APD 903B inactive. Also, the B signal can be generated from the pixel values obtained from the unit pixels 910 with the APD 903A inactive and the APD 903B active. Accordingly, phase-difference detection type autofocus can be performed based on the phase difference between the A signal and the B signal.

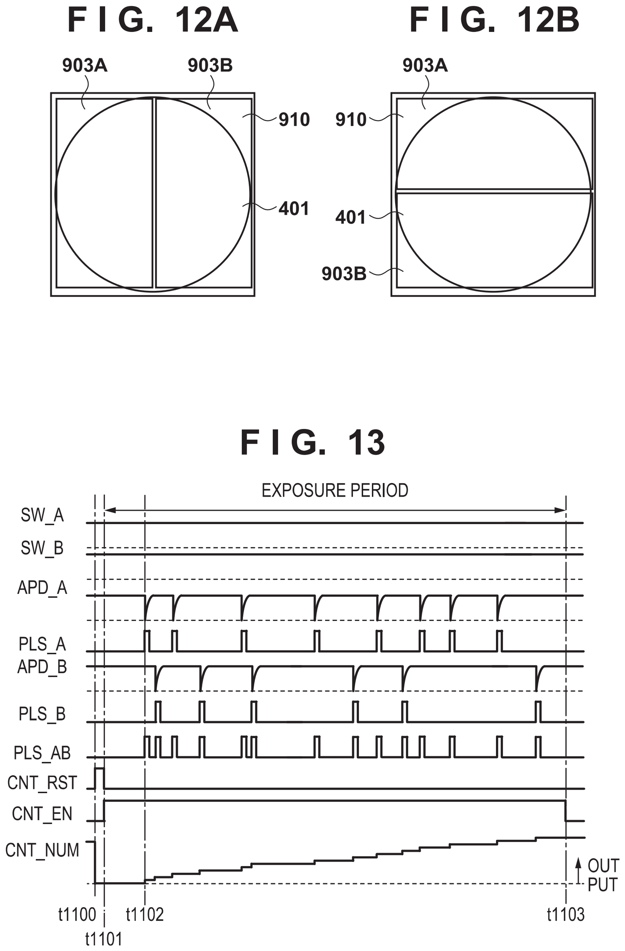

FIGS. 12A and 12B are diagrams illustrating arrangement examples of the photoelectric conversion area (APD 903) in the unit pixel 910. The photoelectric conversion area of the two APDs 903A and 903B provided in the unit pixel 910 may be arranged horizontally side-by-side as illustrated in FIG. 12A or vertically side-by-side as illustrated in FIG. 12B. Both the unit pixel having the arrangement of FIG. 12A and the unit pixel having the arrangement of FIG. 12B may be arranged.

In the present embodiment, all of the unit pixels provided in the pixel array of the image sensor 10 are assumed to have the configuration of FIG. 10. However, in a similar manner to the focus pixel 120 according to the first embodiment, only a portion of the pixels discretely positioned may have the configuration of FIG. 10, and the remaining unit pixels may have a configuration similar to that of the normal pixels 130 according to the first embodiment.

In the following description, for the sake of convenience, the following signal names will be used:
· APD_A: Waveform generated by the quenching resistor 901A, the switch 902A, and the APD 903A (input of the buffer 904A);
· APD_B: Waveform generated by the quenching resistor 901B, the switch 902B, and the APD 903B (input of the buffer 904B);
· PLS_A: Output of the buffer 904A;
· PLS_B: Output of the buffer 904B;
· PLS_AB: Output of OR circuit 913;
· SW_A: Signal for controlling the opening and closing of the switch 902A;
· SW_B: Signal for controlling the opening and closing of the switch 902B;
· CNT_RST: Signal for resetting the count value of the counter 212;
· CNT_EN: Signal for controlling the counting operation of the counter 212; and
· CNT_NUM: The count value of the counter 212.

Of these, the control signals SW_A, SW_B, CNT_RST, and CNT_EN are supplied from the timing generation circuit 12 according to control by the control circuit 30. Alternatively, a circuit for generating these control signals may be provided on the circuit substrate 200.

FIG. 13 is a timing chart illustrating an example of operations of the unit pixel 910 at the time of image capture in the image sensor 10. Here, the operations in a case where the unit pixel 910 is caused to function as a normal pixel during the exposure period will be described. The operations illustrated in FIG. 13 are performed in parallel for each of the unit pixels 910, and an optical image of the subject is converted into image data.

When the switch control signal SW_A goes to high level (referred to below as "H"), the switch 902A is closed and the APD 903A operates in Geiger mode in an active state. On the other hand, when the switch control signal SW_A goes to low level (referred to below as "L"), the switch 902A is opened and the reverse bias voltage applied to the APD 903A becomes equal to or less than the breakdown voltage. Accordingly, the APD 903A is in an inactive state in which avalanche multiplication is not produced even if a photon is incident. In a similar manner, the switch control signal SW_B controls the active state and the inactive state of the APD 903B.

When the counter reset signal CNT_RST becomes "H", the count value of the counter 212 is reset to 0. Also, the counter 212 counts the pulse number only during the time period in which the counter enable signal CNT_EN is "H".

The driving in a case where the unit pixel 910 is caused to function as a normal pixel will now be described. In this case, in order to make both the APDs 903A and 903B active, the switch control signals SW_A and SW_B are maintained at "H".

At time t1100, the counter reset signal CNT_RST goes to "H" and the count value of the counter 212 is reset to 0.

At time t1101 when the exposure period starts, the counter reset signal CNT_RST goes to "L" and resetting of the counter 212 ends. At the same time, the counter enable signal CNT_EN goes to "H" and the counting operation of the counter 212 is started.

At time t1102, when a photon is incident on the APD 903A, an avalanche multiplication is produced, and the APD_A potential changes. Since the charge produced by the avalanche multiplication is discharged via the quenching resistor 901A, it takes time for the APD_A to become a constant potential again. Also, the output PLS_A of the buffer 904A returns to "L" after going to the "H" level for a short amount of time in response to the falling edge of the APD_A. In this manner, the buffer 904A generates a voltage pulse when a photon is incident on the APD 903A. The voltage pulses are counted by the counter 212 via the OR circuit 913 and the comparator 211, and the count value CNT_NUM of the counter 212 goes from 0 to 1.

Thereafter, in the time until time t1103 when the exposure period ends, a voltage pulse is generated by the buffer 904A each time a photon is incident on the APD 903A and by the buffer 904B each time a photon is incident on the APD 903B, and the count value of the counter 212 increases.

At time t1103, the counter enable signal CNT_EN goes to "L" and the exposure period ends. The counter 212 outputs the count value at the time when the exposure period ended to the signal processing circuit 220 as the value of the unit pixel 910 as a normal pixel. From the count values of the unit pixels 910 caused to function as normal pixels, captured image data for display or recording can be generated.

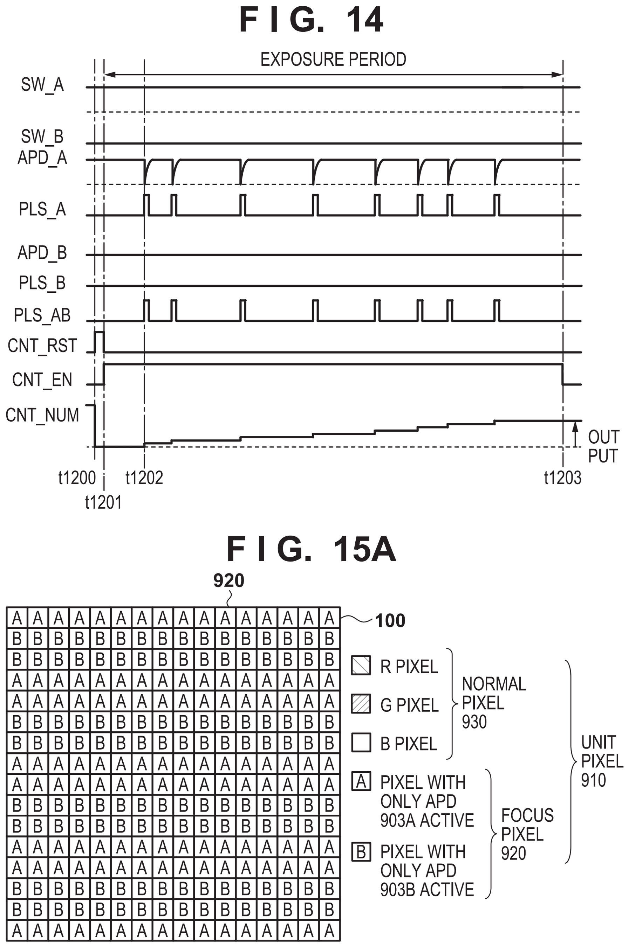

The operations in a case where the unit pixel 910 is caused to function as a focus pixel during the exposure period will now be described using FIG. 14. Here, a case where the APD 903A of the unit pixel 910 is active and the APD 903B is inactive will be described. In the following description, the unit pixel 910 with the APD 903A in an active state and the APD 903B in an inactive state will be referred to as a focus pixel 920A. Also, the unit pixel 910 with the APD 903A in an inactive state and the APD 903B in an active state will be referred to as a focus pixel 920B.

A description of a case where the unit pixel 910 is caused to function as the focus pixel 920B will be omitted, but the description can be interpreted by switching the descriptions relating to the active APD and the inactive APD.

When the switch control signal SW_A goes to high level (referred to below as "H"), the switch 902A is closed and the APD 903A operates in Geiger mode in an active state. On the other hand, when the switch control signal SW_A goes to low level (referred to below as "L"), the switch 902A is opened and the reverse bias voltage applied to the APD 903A becomes equal to or less than the breakdown voltage. Accordingly, the APD 903A is in an inactive state in which avalanche multiplication is not produced even if a photon is incident. In a similar manner, the switch control signal SW_B controls the active state and the inactive state of the APD 903B.

When the counter reset signal CNT_RST becomes "H", the count value of the counter 212 is reset to 0. Also, the counter 212 counts the pulse number only during the time period in which the counter enable signal CNT_EN is "H".

To make the APD 903A active and the APD 903B inactive, the switch control signal SW_A is maintained at "H", and the switch control signal SW_B is maintained at "L".

At time t1200, the counter reset signal CNT_RST goes to "H" and the count value of the counter 212 is reset to 0.

At time t1201 when the exposure period starts, the counter reset signal CNT_RST goes to "L" and resetting of the counter 212 ends. At the same time, the counter enable signal CNT_EN goes to "H" and the counting operation of the counter 212 is started.

At time t1202, when a photon is incident on the APD 903A, an avalanche multiplication is produced, and the APD_A potential changes. Since the charge produced by the avalanche multiplication is discharged via the quenching resistor 901A, it takes time for the APD_A to become a constant potential again. Also, the output PLS_A of the buffer 904A returns to "L" after going to the "H" level for a short amount of time in response to the falling edge of the APD_A. In this manner, the buffer 904A generates a voltage pulse when a photon is incident on the APD 903A. The voltage pulses are counted by the counter 212 via the OR circuit 913 and the comparator 211, and the count value CNT_NUM of the counter 212 goes from 0 to 1.

Thereafter, in the time until time t1203 when the exposure period ends, a voltage pulse is generated by the buffer 904A each time a photon is incident on the APD 903A and the count value of the counter 212 increases. Note that since the APD 903B is inactive, the potential APD_B and the output PLS_B of the buffer 904B are always "L" regardless of whether or not a photon is incident on the APD 903B.

At time t1203, the counter enable signal CNT_EN goes to "L" and the exposure period ends. The counter 212 outputs the count value at the time when the exposure period ended to the signal processing circuit 220 as the value of the unit pixel 910 as a focus pixel A.

For example, image plane phase-difference detection type autofocus can be performed by the A signal being generated from the count values of the plurality of unit pixels 910 caused to function as the focus pixels 920A and the B signal being generated from the count values of the plurality of unit pixels 910 caused to function as the focus pixels 920B.

### Pixel Reading Method Example

FIGS. 15A to 15C are diagrams illustrating examples of a reading method for pixels provided in the pixel array in the sensor substrate 100. A pixel reading method is synonymous with causing each of the unit pixels 910 to function as either the normal pixel 930, the focus pixel 920A, or the focus pixel 920B. The focus pixels 920A and 920B are collectively referred to as the focus pixels 920 below.

The image sensor 10 according to the present embodiment has a configuration in which one counter 212 is provided per unit pixel 910. Thus, from the same unit pixel 910, for one time of exposure, a value of one type of pixel from among the focus pixels 920A and 920B and the normal pixel 930 is obtained.

Thus, for each exposure, whether to cause each of the unit pixels 910 to function as the focus pixel 920A or 920B or the normal pixel 930 is selected. Specifically, one of the following can be selected:
(1) all of the unit pixels 910 set as normal pixels,
(2) all of the unit pixels 910 set as focus pixels, or
(3) a mix of unit pixels 910 set as normal pixels and unit pixels 910 set as focus pixels.

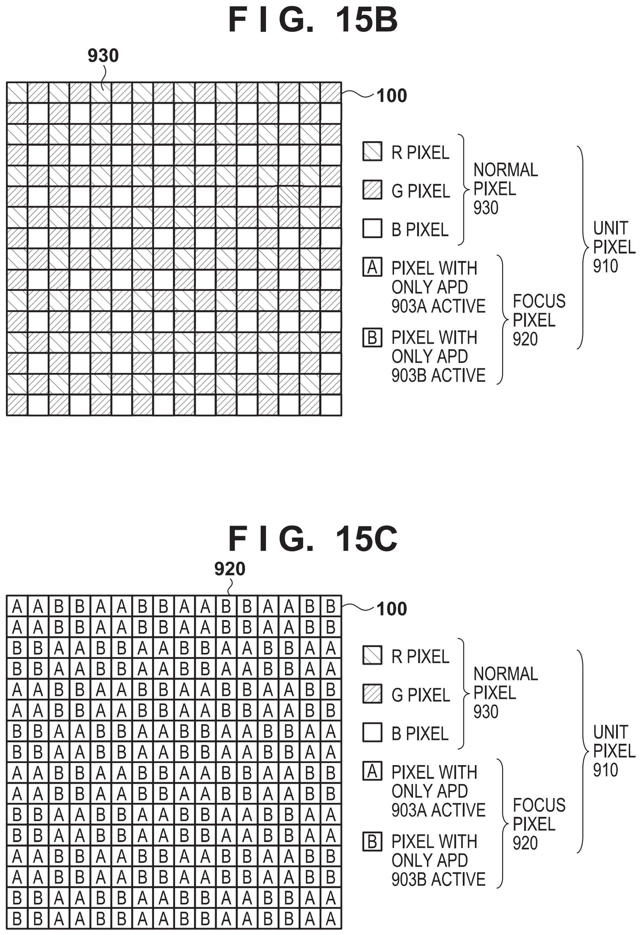

FIGS. 15A and 15C illustrate examples of (2), and FIG. 15B illustrates an example of (1).

**In** a case where all of the unit pixels 910 are caused to function as focus pixels, any position in the screen can be focused on. In FIGS. 15A and 15C, the arrangement of the focus pixels 920A and 920B is different. The arrangement patterns that can be implemented may differ depending on the structure of the wiring that supplies the switch control signal to the unit pixels 910. A case where the switch control signals supplied to each unit pixel can be switched creates the most flexible arrangement, but the wiring becomes complex.

The arrangement of FIG. 15A can be implemented if a control signal supplied to the unit pixel 910 can be set per pixel row. The arrangement of FIG. 15C can be implemented if a control signal supplied to the unit pixel 910 can be set per pixel row and pixel column. The arrangement of FIG. 15C can give greater autofocus accuracy compared to the arrangement of FIG. 15A.

The case of (3) has the advantage that three types of pixel values can be obtained in the same exposure period. However, since interpolation is required when the unit pixels 910 set as focus pixels generate a captured image, this arrangement is not suited to cases that require a captured image of high image quality. Also, to suppress a reduction in image quality, as in the first embodiment, the unit pixels 910 set as focus pixels need to be discretely arranged. However, in a difference with the first embodiment, the positions of the unit pixels 910 set as focus pixels can dynamically change.

**In** the case of (1) and (2), a captured image and a focus signal cannot be obtained with one time of exposure. Thus, it is desirable to increase the image capture frame rate or the like so that the obtainment interval does not degrade.

**In** practice, (1) to (3) can be dynamically changed per exposure according to a condition, for example. Examples of the condition can include the operation status of the image capture apparatus 1 (in a standby state or recording), prioritizing image quality or autofocus tracking performance, the image capturing scene (whether the scene makes autofocus difficult such as a scene with low contrast), and the like, but the condition is not limited to these examples. Switching the pixel arrangement is implemented by the control circuit 30 controlling the timing generation circuit 12 and switching the state (H level or L level) of the control signals supplied to the unit pixels 910.

For example, in an image capture standby state, a video for live view display is usually being captured. Thus, a captured image as (1) can be obtained for a certain frame, and a focus signal as (2) can be obtained for a different frame.

Alternatively, as (3), a captured image and a focus signal may be obtained for each frame. Since the image for live view display may have lower resolution than an image for recording and the demand for image quality is low, there is no problem if focus pixels are included.

For example, when an image for live view display is generated, to lower the resolution, the pixel values may be added and averaged, the pixel values may be thinned, or the like. In such cases, the thinned pixels can be used as the focus pixels.

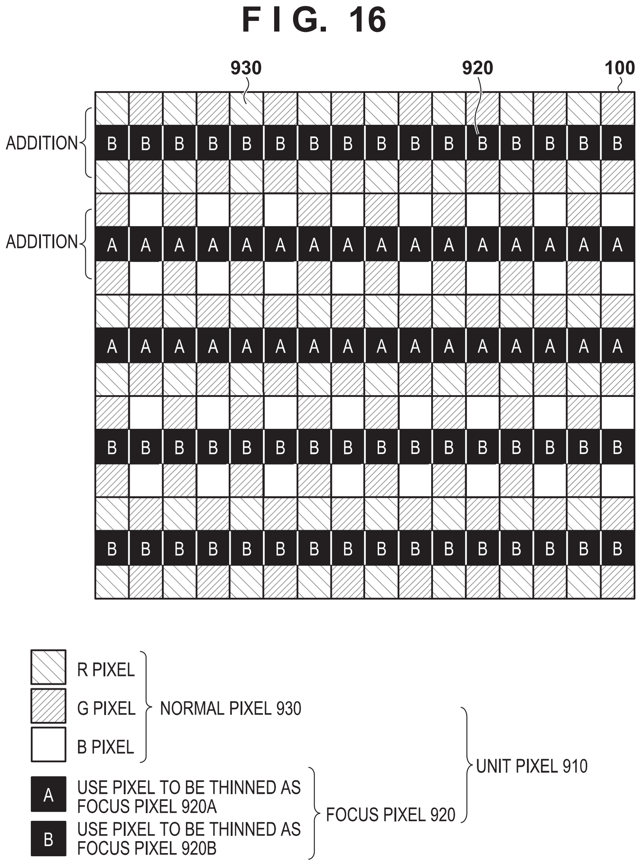

FIG. 16 is a diagram illustrating an example of a pixel arrangement in a case where a low resolution captured image is generated by thinning one row per three rows and performing adding and averaging for the remaining two rows. In the illustrated example, for three consecutive pixel rows, the middle pixel row is thinned, and adding and averaging is performed for the remaining two pixel rows. Note that for the sake of convenience, only a method of lowering resolution in the vertical direction is illustrated here. In this manner, by causing the unit pixels that are known in advance to be subjected to thinning to function as focus pixels, interpolation to obtain the values of positions of focus pixels when generating a captured image (image for live view display) can be made unnecessary.

Also, (1) can be set at the time of still image capture, and (1) and (2) can be dynamically switched at the time of video capture for recording. In order to maintain the recording frame rate during video capture for recording, the image capture frame rate may be set higher than the recording frame rate.

Also, in the case of (2), whether to arrange one type of focus pixel or two types of focus pixels can be made selectable. For example, in the case of a high frame rate, all of the unit pixels 910 may be set as the focus pixels 920A in a certain frame, and all of the unit pixels 910 may be set as the focus pixels 920B in the next frame. In this case, since the A signal and the B signal can be obtained from the same unit pixel, an increase in autofocus accuracy is expected particularly in the case of image capture of a subject with little movement.

Note that in the examples described here, two photoelectric conversion elements are provided in a unit pixel. However, the number of photoelectric conversion elements provided in a unit pixel may be greater than two. For example, two photoelectric conversion elements may be provided in each of the horizontal and vertical direction in a unit pixel so that a total of four photoelectric conversion elements are provided. This allows a configuration in which both of the forms illustrated in FIGS. 12A and 12B can be used.

Also, in the present embodiment, as in the first embodiment, sensitivity adjustment of the unit pixels using the duty ratio of the switch control signal SW_V may be performed.

In the present embodiment, a plurality of the photoelectric conversion elements (APDs) are provided in a unit pixel, and turning the APDs on (active) and off (inactive) can be individually controlled. Thus, in addition to a similar effect to the first embodiment, a flexible focus pixel arrangement can be achieved. Also, in a case where all of the unit pixels are caused to function as normal pixels, a captured image with a higher image quality than that of the first embodiment can be obtained.

### Other Embodiments

Embodiment(s) of the present disclosure can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)^{™}), a flash memory device, a memory card, and the like.

Various embodiments have been described in detail above but it will be understood that the present disclosure is not limited to these embodiments and encompasses all modifications, variants, alternatives and equivalents falling within the scope of the appended claims.

## Claims

1. An image sensor (10) comprising:
a plurality of pixels (110) configured to output pulses in response to photon incidence; and
a plurality of counters (212) provided in one-to-one correspondence to the plurality of pixels (110) and configured to count pulses output by the corresponding pixel (110), wherein the plurality of pixels (110) includes a focus pixel (120).

2. The image sensor (10) according to claim 1, wherein
the focus pixel (120) includes a light-blocking element (500) configured to block light in a portion of a photoelectric conversion area.

3. The image sensor (10) according to claim 2, wherein
among the plurality of pixels (110), a pixel that is not the focus pixel does not include the light-blocking element (500).

4. The image sensor (10) according to claim 2, wherein
each of the plurality of pixels (110) has an active state and an inactive state, and
during an exposure period, the focus pixel (120) has a longer active state time period than a pixel that is not the focus pixel among the plurality of pixels.

5. The image sensor (10) according to claim 1, wherein
the focus pixel (120) includes a plurality of photoelectric conversion elements (903A, 903B), and
a portion of the plurality of photoelectric conversion elements (903A, 903B) is controlled to be in an active state.

6. The image sensor (10) according to claim 5, wherein
each of the plurality of pixels (110) include a plurality of photoelectric conversion elements (903A, 903B), and
the plurality of photoelectric conversion elements (903A, 903B) of pixels (110) that are not the focus pixel are controlled to be in an active state.

7. An image sensor (10) comprising:
a plurality of pixels (110) configured to output pulses in response to photon incidence, each of the plurality of pixels (110) including one or more photoelectric conversion elements (103, 903A, 903B); and
a plurality of counters (212) respectively provided for the plurality of pixels (110) and configured to count pulses output by the corresponding pixel (110), wherein
a pixel (110) including a plurality of the photoelectric conversion elements (903A, 903B) includes a switch (902A, 902B) for controlling one of the plurality of the photoelectric conversion elements (903A, 903B) to be in an active state and controlling a remainder to be in an inactive state.

8. The image sensor (10) according to claim 7, wherein
the pixel (110) including the plurality of the photoelectric conversion elements (903A, 903B) is a focus pixel (120).

9. The image sensor (10) according to any one of claims 1 to 8, wherein
the plurality of pixels (110) are provided on a first substrate (100),
the counters (212) are provided on a second substrate (200), and
the first substrate (100) and the second substrate (200) are stacked in such a manner as to be electrically connected.

10. An image capture apparatus (1) comprising:
the image sensor (10) according to any one of claims 1 to 6 and 8; and
a controller (30) that executes phase-difference detection type autofocus based on pixel values of focus pixels.

11. An image capture apparatus (1) comprising:
the image sensor (10) according to claim 5 or 6; and
a controller (30) that performs control to cause each of the plurality of pixels (110) to function as either a normal pixel (130) in which the plurality of photoelectric conversion elements (903A, 903B) are set to an active state or a focus pixel (120) in which a portion of the photoelectric conversion elements (903A, 903B) is set to an active state and remaining photoelectric conversion elements are set to an inactive state.

12. The image capture apparatus (1) according to claim 11, wherein
the controller (30) dynamically switches between a case of causing all of the plurality of pixels (110) to function as the normal pixel (130) and a case of causing all of the plurality of pixels (110) to function as the focus pixel (120).

13. The image capture apparatus (1) according to claim 11, wherein
the controller (30) causes a portion of the plurality of pixels (110) to function as the focus pixel (120) and causes a remainder to function as the normal pixel (130).

14. The image capture apparatus (1) according to claim 13, wherein
the controller (30) causes pixels thinned from among the plurality of pixels (110) to function as the focus pixel (120).
